Europäisches Patentamt

European Patent Office

Office européen des brevets

(19)

(11) Veröffentlichungsnummer : **0 131 229**
**B1**

(12) # EUROPÄISCHE PATENTSCHRIFT

(45) Veröffentlichungstag der Patentschrift :
11.02.87

(51) Int. Cl.⁴ : **G 01 R 15/00, G 08 C 15/06**

(21) Anmeldenummer : **84107655.7**

(22) Anmeldetag : **02.07.84**

(54) **Schaltungsanordnung zur Ausgabe von Analogsignaien.**

(30) Priorität : **11.07.83 DE 3324954**

(43) Veröffentlichungstag der Anmeldung :
**16.01.85 Patentblatt 85/03**

(45) Bekanntmachung des Hinweises auf die Patenterteilung : **11.02.87 Patentblatt 87/07**

(84) Benannte Vertragsstaaten :
**CH DE FR GB LI NL SE**

(56) Entgegenhaltungen :
**DE-B- 2 203 306**
**US-A- 4 242 907**
**ELECTRONIC DESIGN, Band 28, Nr. 6, 15. März 1980, Seiten 283-285, Rochelle Park, USA; J.V. DiROCCO et al.: "Mate low-level thermocouples to muCs easily with a flying-capacitor multiplexer"**

(73) Patentinhaber : **Siemens Aktiengesellschaft Berlin und München**
**Witteisbacherplatz 2**
**D-8000 München 2 (DE)**

(72) Erfinder : **Muhr, Andreas, Dipl.-Ing.**
**Starenweg 1**
**D-7515 Linkenheim (DE)**

EP 0 131 229 B1

## Beschreibung

Die Erfindung betrifft eine Schaltungsanordnung zur Ausgabe von Analogsignalen gemäß dem Oberbegriff des Anspruchs 1. Eine solche Anordnung ist im wesentlichen aus der Literaturstelle « Prozeßrechner » von K. Anke, 1970, Seiten 493 bis 498 bekannt.

Prozeßrechnersysteme enthalten sogenannte Analogausgaben, welche aus digitalen Werten analoge Signale, d. h. Ströme oder Spannungen, bilden und diese an periphere Geräte wie Schreiber oder Stellglieder ausgeben. Im allgemeinen steuert eine Analogausgabe mehrere periphere Geräte über einen Multiplexer an, wozu jeder Analogkanal einen Ausgabeverstärker mit einem Speicher enthält, in welchem nach Art einer Abtast- und Halteschaltung der Analogwert zwischen den Ansteuerungen durch den Multiplexer gespeichert wird. Dabei tritt das Problem auf, daß die peripheren Geräte und die Analogausgabe auf unterschiedlichem Erdpotential liegen können, so daß auf dem Weg von der Analogausgabe zum peripheren Gerät sich dem analogen Wert eine Störspannung überlagern kann, die außerdem im allgemeinen von Gerät zu Gerät unterschiedlich ist. Diese Störspannung kann man mit großem Aufwand dadurch unwirksam machen, daß man die einzelnen Analogkanäle zu den peripheren Geräten potentialgetrennt ausführt oder daß man jedem Analogkanal einen Trennverstärker vorschaltet, der über eine Drei- oder Vierleiterschaltung die Fehler am Stellglied korrigiert.

Der vorliegenden Erfindung liegt die Aufgabe zugrunde, eine Schaltungsanordnung zu schaffen, in welcher das Problem der Potentialunterschiede zwischen den peripheren Geräten und der sie ansteuernden Schaltung mit geringem Aufwand gelöst ist.

Erfindungsgemäß wird diese Aufgabe mit den im kennzeichnenden Teil des Anspruchs 1 angegebenen Schaltungsmaßnahmen gelöst.

Der Multiplexer weist in der neuen Anordnung je Analogkanal einen zusätzlichen Schaltkontakt auf, über den das Potential am Fußpunkt der Bürde auf den Differenzverstärker geführt ist. Die durch einen etwaigen, im Zeitpunkt der Aufschaltung der analogen Spannung auf die Bürde bestehenden Potentialunterschied bewirkte Störspannung wird damit kompensiert. Es ist daher möglich, mit einer gemeinsamen Potentialleitung alle Bürden zu versorgen, und zwar sowohl in Sternschaltung als auch dadurch, daß die Potentialleitung von Bürde zu Bürde geführt wird. Damit wird eine erhebliche Ersparnis gegenüber der Anordnung von je einem Trennverstärker in den Analogkanälen und vier Leitern erzielt.

Sind die Potentiale an den Fußpunkten der Bürden auf den jeweils zugehörigen Ausgabeverstärker derart geführt, daß sie zu den Spannungen in den Speichern addiert werden, so werden auch Potentialänderungen zwischen den Zeitpunkten, zu denen der Multiplexer die Analogsignale auf die Ausgabeverstärker schaltet, ausgeregelt.

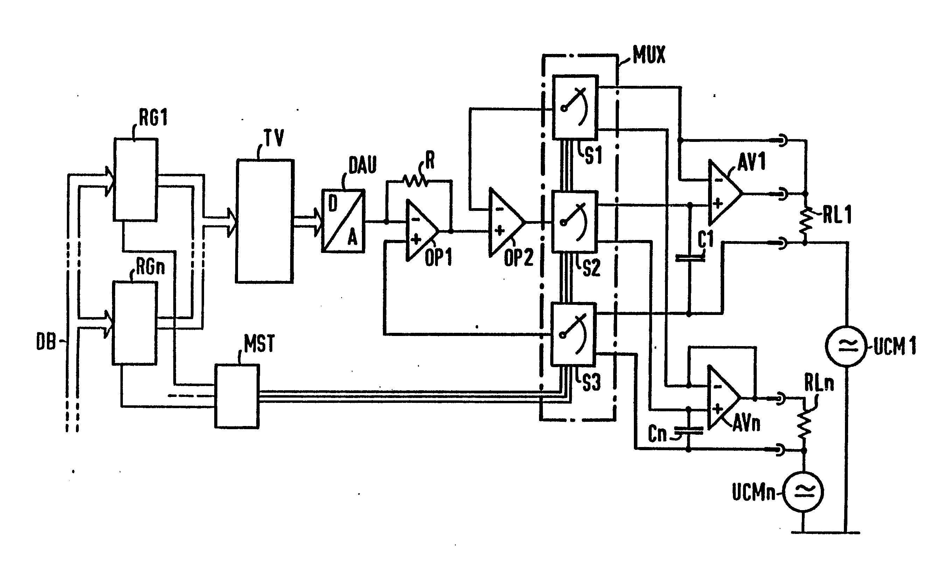

Anhand der Zeichnung werden im folgenden die Erfindung sowie weitere Ausgestaltungen und Ergänzungen näher beschrieben und erläutert.

Mit RG1 ... RGn sind Register bezeichnet, in die über eine Busleitung DB digitale Werte eingetragen werden, die als Analogsignale an je eine Bürde RL1 ... RLn ausgegeben werden sollen. Die Ausgänge der Register RG1 ... RGn sind über eine gemeinsame Leitung und einen Trennverstärker TV, der die Register von der nachfolgenden Schaltung galvanisch trennt, mit dem Eingang eines Digital-Analog-Umsetzers DAU verbunden. Dieser liefert einen, dem jeweils zugeführten Digitalwert entsprechenden eingeprägten Strom an den invertierenden Eingang eines Operationsverstärkers OP1, der mittels eines Gegenkopplungswiderstandes R als Stromspannungswandler geschaltet ist. Auf ihn folgt ein zweiter Operationsverstärker OP2, dessen Ausgangssignal von einem Schalter S2 eines Multiplexers MUX auf einen von mehreren Ausgabeverstärkern AV1 ... AVn führt, welche die Bürden RL1 ... RLn speisen. An den Eingängen der Ausgabeverstärker liegen Speicherkondensatoren C1 ... Cn. Die Ausgangssignale der Ausgabeverstärker sind auf deren invertierenden Eingänge und über einen Schalter S1 des Multiplexers MUX auf den invertierenden Eingang des Operationsverstärkers OP2 rückgeführt. Etwaige Störpotentiale $U_{CM1}$ ... $U_{CMn}$ an den Fußpunkten der Bürden RL1 ... RLn werden über Schalter S3 des Multiplexers MUX auf den nicht invertierenden Eingang des Operationsverstärkers OP1 geschaltet. Die Speicherkondensatoren C1 ... Cn liegen zwischen den Verbindungsleitungen von den Fußpunkten der Bürden zu den Schaltern S3, so daß sich die Spannungen an den Speicherkondensatoren zu den Fußpunktpotentialen $U_{CM1}$ ... $U_{CMn}$ addieren. Eine Multiplexersteuerung MST ruft die Inhalte der Register RG1 ... RGn einzeln ab und schaltet gleichzeitig den Multiplexer MUX derart, daß die in den Registern enthaltenen Digitalwerte nach Digital-Analog-Umsetzung auf die mit denselben Indizes bezeichneten Bürden geschaltet werden und gleichzeitig die Spannung an der jeweiligen Bürde auf die Operationsverstärker OP1, OP2 rückgeführt wird. Die Störpotentiale am Fußpunkt der Bürde RL1 bzw. RLn werden im Operationsverstärker OP1 von den vom Digital-Analog-Umsetzer gelieferten Signalen subtrahiert, so daß der jeweils angeschalteten Bürde die richtige Spannung zugeführt wird. Der Ausgang des Digital-Analog-Umsetzers DAU ist als Stromquelle ausgebildet, damit er unabhängig davon, welches Potential am Fußpunkt der Bürde besteht, ein dem Digitalwert proportionales Analogsignal liefert. In den Speichern C1 ... Cn wird die Steuerspannung für die Ausgabeverstärker AV1 ... AVn gespeichert, die erforderlich ist, um die richtigen Spannungswerte an den Bürden aufrechtzuerhalten, wenn der Multiplexer die jeweils anderen Ausgabeverstärker anschaltet, und zwar auch dann, wenn die Störspannungen $U_{CM1}$ ... $U_{CMn}$ Wechselspannungen sind.

## Patentansprüche

1. Schaltungsanordnung zur Ausgabe von Analogsignalen mit einem Multiplexer (MUX), dem die Analogsignale zugeführt sind und der diese zyklisch auf je einen Speicher (C1 ... Cn) enthaltende Ausgabeverstärker (AV1 ... AVn) schaltet, deren Ausgänge jeweils an den ersten Anschluß einer Bürde (RL1 ... RLn) angeschlossen sind, deren zweiter Anschluß (Fußpunkt) mit einem konstanten Potential verbunden ist, dadurch gekennzeichnet,

a) daß im Analogsignalweg vor dem Multiplexer (MUX) eine Stromquelle (DAU) angeordnet ist, an die der eine Eingang eines als Stromspannungswandlers geschalteten Differenzverstärkers (OP1) angeschlossen ist und

b) daß die Potentiale an den Fußpunkten der Bürden (RL1 ... RLn) über den Multiplexer (S3) auf den zweiten Eingang des Differenzverstärkers (OP1) geführt sind.

2. Schaltungsanordnung nach Anspruch 1, dadurch gekennzeichnet, daß die Potentiale an den Fußpunkten der Bürden (RL1 ... RLn) auf den jeweils zugehörigen Ausgabeverstärkern (AV1 ... AVn) derart geführt sind, daß sie zu den Spannungen in den Speichern (C1 ... Cn) addiert werden.

3. Schaltungsanordnung nach Anspruch 2, dadurch gekennzeichnet, daß die Ausgabeverstärker je einen Differenzverstärker enthalten, dessen nicht invertierendem Eingang das Analogsignal zugeführt ist und zwischen dessen nichtinvertierenden Eingang und den Fußpunkt der Bürde ein Kondensator (C1 ... Cn) als Speicher geschaltet ist.

4. Schaltungsanordnung nach einem der Ansprüche 1 bis 3, dadurch gekennzeichnet, daß zur Ausgabe von Analogsignalen mit Potentialtrennung aus einer Datenverarbeitungsanlage die auszugebenden Signale in digitaler Form über eine Einrichtung zur Potentialtrennung (TV) geführt sind, der ein als Stromquelle wirkender Digital-Analog-Umsetzer (DAU) nachgeschaltet ist, welcher jeweils einen, dem zugeführten Digitalwert entsprechenden Strom dem Stromspannungswandler (OP1) zuführt.

## Claims

1. A circuit arrangement for the output of analogue signals, comprising a multiplexer (MUX) supplied with the analogue signals and which cyclically switches said analogue signals to output amplifiers (AV1 ... AVn), each of which contains a store (C1 ... Cn), the outputs of which amplifiers are each connected to the first terminal of a load (RL1 ... RLn), whose second terminal (base-point) is connected to a constant potential, characterised in that

a) in the analogue signal path the multiplexer (MUX) is preceded by a current source (DAU) connected to one input of a differential amplifier (OP1) forming a current-voltage converter, and that

b) the potentials at the base-points of the loads (RL1 ... RLn) lead *via* the multiplexer (S3) to the second input of the differential amplifier (OP1).

2. A circuit arrangement as claimed in Claim 1, characterised in that the potentials at the base-points of the loads (RL1 ... RLn) each lead to the associated output amplifiers (AV1 ... AVn) in such manner that they are added to the voltages in the stores (C1 ... Cn).

3. A circuit arrangement as claimed in Claim 2, characterised in that the output amplifiers each contain a differential amplifier, the non-inverting input of which is supplied with the output signal, and between the non-inverting input of which and the base of the load a capacitor (C1 ... Cn) is connected as a store.

4. A circuit arrangement as claimed in one of Claims 1 to 3, characterised in that in order to produce analogue output signals whose potential is isolated from a data processing system, the signals to be output are fed in digital form *via* a potential isolating device (TV), the output of which is connected to a digital-analogue-converter (DAU) which serves as a current source and in each case supplies the current-voltage converter (OP1) with the current corresponds to the supplied digital value.

## Revendications

1. Montage pour la sortie de signaux analogiques, comprenant un multiplexeur (MUX) auquel sont amenés les signaux analogiques et qui les envoie de façon cyclique à des amplificateurs de sortie (AV1 ... AVn) contenant chacun une mémoire (C1 ... Cn) et dont les sorties sont connectées chacune à la première borne d'une charge (RL1 ... RLn) dont la seconde borne (base) est reliée à un potentiel constant, caractérisé en ce que

a) le chemin des signaux analogiques contient, avant le multiplexeur (MUX), une source de courant (DAU) à laquelle est connectée l'une des entrées d'un amplificateur différenciateur (OP1) monté en transformateur courant-tension et

b) les potentiels aux bases des charges (RL1 ... RLn) sont appliqués à travers le multiplexeur (S3) à la seconde entrée de l'amplificateur différenciateur (OP1).

2. Montage selon la revendication 1, caractérisé en ce que les potentiels sur les bases des charges (RL1 ... RLn) sont appliqués aux amplificateurs de sortie (AV1 ... AVn) correspondants, de manière qu'ils soient additionnés aux tensions dans les mémoires (C1 ... Cn).

3. Montage selon la revendication 2, caractérisé en ce que les amplificateurs de sortie contiennent chacun un amplificateur différenciateur, à l'entrée non inverseuse duquel est amené le signal analogique et entre l'entrée non inverseuse duquel et la base de la charge, un condensateur (C1 ... Cn) est monté en tant que mémoire.

4. Montage selon une des revendications 1 à 3, caractérisé en ce que, pour la sortie de signaux analogiques avec séparation des potentiels d'un ordinateur, les signaux à sortir sont acheminés sous forme numérique à travers un dispositif (TV) pour la séparation des potentiels, qui est suivi par un convertisseur numérique-analogique (DAU) agissant comme source de courant et qui envoie chaque fois un courant correspondant à la valeur numérique qui lui est appliquée au transformateur de courant-tension (OP1).